**Europäisches Patentamt**

**European Patent Office**

**Office européen des brevets**

(19)

(11) Publication number : **0 535 711 A2**

(12) # EUROPEAN PATENT APPLICATION

(21) Application number : **92116966.0**

(22) Date of filing : **05.10.92**

(51) Int. Cl.⁵ : **H05K 1/00**

(30) Priority : **04.10.91 JP 257553/91**
**15.11.91 JP 300123/91**
**12.12.91 JP 328567/91**

(43) Date of publication of application :
**07.04.93 Bulletin 93/14**

(84) Designated Contracting States :
**DE GB**

(71) Applicant : **MATSUSHITA ELECTRIC INDUSTRIAL CO., LTD.**
**1006, Oaza Kadoma**
**Kadoma-shi, Osaka-fu, 571 (JP)**

(72) Inventor : **Nakatani, Seiichi**
**11-29-16, Korigaoka**
**Hirakata-shi, Osaka-fu (JP)**

Inventor : **Yuhaku, Satoru**
**3-5-5, Tsuruhashi, Ikuno-ku**
**Osaka-shi, Osaka-fu (JP)**
Inventor : **Shimada, Mikinari**
**1-8-20-202, Yamanoue**
**Hirakata-shi, Osaka-fu (JP)**
Inventor : **Nakamura, Yoshifumi**
**22-7, Korinishinomachi**
**Neyagawa-shi, Osaka-fu (JP)**
Inventor : **Miura, Kazuhiro**
**4-19-26, Takadono, Asahi-ku**
**Osaka-shi, Osaka-fu (JP)**
Inventor : **Nishikawa, Hidenobu**
**5-22-13, Toda-cho**
**Moriguchi-shi, Osaka-fu (JP)**

(74) Representative : **Eisenführ, Speiser & Partner**
**Martinistrasse 24**
**W-2800 Bremen 1 (DE)**

(54) **Method for producing multilayered ceramic substrate.**

(57) A multilayered ceramic substrate which shrinks only in a thickness direction but does not shrink in a plane direction is produced by forming at least two green sheets each of which comprises a glass-ceramic low-temperature firing substrate material, an organic binder and a plasticizer, forming an electrode pattern with a conductor paste composition on each of the green sheets, laminating the green sheets having the electrode pattern to obtain a laminate, laminating a pair of green sheets each comprising an inorganic material which is not sintered at a sintering temperature of the green sheets of the low-temperature firing substrate material or lower on both surfaces of the laminate, sintering the laminate sandwiched by the green sheets comprising the inorganic material, and removing the unsintered inorganic material or impregnating the inorganic material layers with a resin and forming a top layer wiring pattern thereon.

Fig. 1

EP 0 535 711 A2

## BACKGROUND OF THE INVENTION

### Field of the Invention

The present invention relates to a method for producing a multilayered ceramic substrate for mounting and interconnecting semiconductor LSI or chip components exterior thereof.

### Description of the Related Art

In these years, with the development of a low-temperature firing glass ceramic multilayered substrate, gold, silver, copper, palladium or their mixtures can be used as a conductor material. These metals have smaller conductor resistances than the conventionally used metals such as tungsten and molybdenum. With these metals, a multilayered ceramic substrate can be produced using a safe equipment at a low cost.

Among these metals, noble metals such as gold, silver and palladium are expensive and their values change greatly. Then, it is desired to use a copper electrode material which is cheap and a value of which does not change greatly.

Now, typical methods for producing a low-temperature firing multilayered substrate will be explained. Roughly speaking, there are three kinds of low-temperature firing multilayered substrates.

A first one uses a silver electrode as an internal electrode of the multilayered substrate and is produced by laminating the desired number of green sheets for the low-temperature firing substrate, sintering the laminated sheets in an air, printing an electrode pattern with a paste of silver-palladium on the top layer and sintering it. This type of the multilayered substrate uses the silver electrode having a low impedance inside and the silver-palladium mixture which is resistant to soldering heat on the top layer.

A second one uses a silver layer as an internal electrode and a copper electrode on the top layer of the multilayered substrate. Since the copper layer is used as the top wiring pattern, it has lower impedance and better solderability than the silver-palladium electrode. But, since copper has a lower eutectic point with silver, a low-temperature firing copper paste (e.g. about 600°C) should be used. As the result, the substrate has some drawbacks such as weak adhesion strength, poor solderability, and the like (see Japanese Patent Publication No. 78798/1991).

A third one uses copper electrodes as the internal electrode and on the top layer. Though this structure is excellent in the conductor resistance, solderability and the cost, the sintering should be carried out in an inert atmosphere so that its production is troublesome. In general, for forming the copper electrodes, a wiring pattern should be formed by screen printing a copper paste on the substrate, drying and sintering it at a temperature lower than a melting point of copper (e.g. a sintering temperature of 800°C to 1000°C) in a nitrogen atmosphere in which an oxygen partial pressure is so controlled that copper is not oxidized but organic materials in the paste are well burnt off. For the formation of a multilayered structure, a dielectric layer is printed and sintered under the same conditions (see Japanese Patent Kokai Publication No. 128899/1980).

However, it is very difficult to control the oxygen partial pressure at a suitable pressure in the sintering step. In addition, for the formation of a multilayered structure, sintering should be repeated after printing of each paste, so that a lead time becomes long and the production cost including the cost of equipments increases.

Japanese Patent Publication No. 20914/1991 discloses a method for producing a multilayered ceramic substrate using a cupric oxide (CuO) paste and consisting of a step for binder burn-out, a step for reduction and a step for sintering. That is, a multilayered body is produced using cupric oxide as a raw material of a conductor, and in the step for binder burn-out, the multilayered body is heated at a temperature sufficient for pyrolysis of the organic binder. In the reducing step, cupric oxide is reduced to metal copper and, in the sintering step, the substrate is sintered. Thereby, a composition of the atmosphere in the sintering step is easily controlled and a dense sintered material is obtained.

The material of the low-temperature firing substrate is sintered at a temperature of about 850°C to 1000°C since it should be sintered at a temperature lower than the melting point of the above metal. As the materials of the low-temperature firing substrate, there are a glass-ceramic composite type, a crystallized glass type, a ceramic composite type, and the like. In particular, a glass-ceramic composite type comprising ceramic fillers such as alumina and the crystallized glass is often used since it can provide a substrate having various combinations of properties such as a coefficient of thermal expansion, a thermal conductivity, a dielectric constant, etc. by the selection of the glass composition and a kind of the ceramic filler.

In general, a weight ratio of the glass to alumina as the ceramic filler is about 50:50, and the composite is sintered at a low temperature of 850°C to 900°C. In the course of sintering, the glass is first softened to form a network of the glass and alumina and then a crystallization reaction takes place at interfaces between the glass and the alumina to obtain a dense sintered body. Therefore, control of a distribution of glass particle size and compatibility between the glass and alumina is a base factor for stable production of the substrate. In view of the above production process and the raw materials, the low-temperature firing substrate is expected to be a substrate for a high density wiring pattern which answers to miniaturization of electronic devices and tendency for high frequency devices.

However, the multilayered ceramic substrate has a following drawback.

The multilayered ceramic substrate shrinks in accordance with sintering. A degree of shrinkage in accordance with sintering varies with the kind of the substrate material, a composition of the green sheet, a powder lot, and the like. This will cause various problems in the production of the multilayered substrate.

First, since the wiring pattern on the top layer is formed after the sintering of the internal wiring pattern in the production of the multilayered ceramic substrate as described above, the internal electrode and the wiring pattern on the top layer cannot be connected due to difference in dimensions between them if the shrinkage error of the sunstrate material is large. As the result, in order to absorb such shrinkage error, a land having an unnecessarily large area should be formed on the top layer electrode, but such electrode is not suitable for a circuit which requires a dense wiring pattern. Alternatively, various screens for the top wiring patterns are provided according to the shrinkage errors and one of them is used according to the specific shrinkage error of the substrate. However, the provision of a number of the screens is not economical.

If the top layer wiring pattern is formed at the same time as the formation of the internal electrode, no large land is necessary. But, in this simultaneous formation, the shrinkage error of the substrate still remains. Therefore, a solder paste pattern for mounting the components may not be printed on required positions due to the shrinkage error of the substrate. In addition, a position of the actually mounted component may deviate from a designed position.

Second, the multilayered ceramic substrate produced by laminating the green sheets has different shrinkage factors in its longitudinal and lateral directions depending on the sheeting directions of the green sheets. This is one of the problems which arise in the production of the multilayered ceramic substrate.

To reduce the shrinkage errors as much as possible, it is necessary to control not only the substrate material and the composition of the green sheet but also the powder lot difference and lamination conditions (e.g. pressing pressure, temperature, etc.). Still, it is said that about ±0.5 % of the error of the shrinkage factor remains.

U.S. Patent Nos. 4,753,694 and 4,879,156 propose a method using solid electrodes and sintering a laminate while pressing it with porous ceramic materials. That is, in this process, since a thick film conductor has a high resistance, a solid electrode pattern such as a copper foil is transferred to a carrier film and a dielectric layer is formed thereon by a green sheet method. After via processing, a multilayered laminate is formed and sandwiched between a pair of porous sintered materials. Then, a composite is placed in a mold and sintered under pressure. By this method, the substrate shrinks in a thickness direction due to pressure while the shrinkage in the plane direction is suppressed. However this process still has the following problem. Since the sintered materials should be sufficiently porous for complete removal of the binder during binder burn-out, they adhere to the substrate during firing and their removal is very difficult. In addition, since the substrate should be fired under pressure, a construction of a firing furnace is complicated and this process is not suitable for mass production.

The above problems are common to the firing substrates made of the ceramics or the glass-ceramics which requires firing. Then, if a substrate which shrinks only in a thickness direction but does not in a plane direction could be produced, the above problems would be solved and such substrate would be industrially attractive.

## SUMMARY OF THE INVENTION

One object of the present invention is to provide a multilayered ceramic substrate which does not shrink in a plane direction and has good dimensional stability and high accuracy.

Another object of the present invention is to provide a multilayered ceramic substrate which can be produced by firing a substrate material without pressing against the stacked green substrates and shrinks only in a thickness direction but does not in a plane direction.

A further object of the present invention is to provide a multilayered ceramic substrate which does not shrink in a plane direction even if it has partly cavities.

According to the present invention, there is provided a method for producing a multilayered ceramic substrate comprising steps of:

forming at least two green sheets each of which comprises a glass-ceramic low-temperature firing substrate material, an organic binder and a plasticizer,

forming an electrode pattern with a conductor paste composition on each of said green sheets

3

laminating said green sheets having the electrode pattern to obtain a laminate,

laminating a pair of green sheets each comprising an inorganic material which is not sintered at a sintering temperature of the green sheets of the low-temperature firing substrate material or lower on both surfaces of said laminate,

sintering said laminate sandwiched by the green sheets comprising the inorganic material, and

removing the unsintered inorganic material or impregnating the inorganic material layers with a resin and forming a top layer wiring pattern thereon.

The method of the present invention produces a multilayered ceramic substrate which shrinks only in the thickness direction but does not in the plane direction during sintering. This may be because the laminate of the green sheets of the glass-ceramic substrate material is sandwiched by the sheets of the inorganic material which is not sintered so that the shrinkage in the plane direction is suppressed.

When the glass-ceramic laminate has cavities on its surface, the cavities are filled with a powder of the inorganic material which is not sintered at the sintering temperature of the glass-ceramic substrate material and then the laminate is sandwiched by a pair of the green sheets of the inorganic material and sintered.

## BRIEF DESCRIPTION OF THE DRAWINGS

Fig. 1 is a cross sectional view of an example of a substrate produced by the method of the present invention,

Fig. 2 is a flow chart of one embodiment of the method for producing a multilayered ceramic substrate according to the present invention,

Fig. 3 is a cross sectional view of a laminate for a multilayered ceramic substrate produced in Example 3,

Fig. 4 is a flow chart of a method carried out in Example 3,

Fig. 5 is a cross sectional view of a multilayered ceramic substrate produced in Example 3 after sintering, and

Fig. 6 is a cross sectional view of a substrate having cavities.

## DETAILED DESCRIPTION OF THE INVENTION

In the method of the present invention, as the glass-ceramic low-temperature firing substrate material, any of conventional used materials may be used. Preferred examples of such material are glasses such as borosilicate glass and lead-borosilicate galss (cf. U.S. Patent No. 5,004,640), and ceramics such as alumina, calcia and magnasium.

Examples of the binder are polyvinyl butyral resins, cellulose derivatives (e.g. ethyl cellulose), (meth)acrylic resins, polyvinyl alcohol and the like.

Examples of the plasticizer are phthalates (e.g. di-n-butyl phthalate, benzyl-n-butyl phthalate, dinonyl phthalate, etc.), aliphatic dibasic acid esters (e.g. di(2-ethylhexyl) adipate or sebacate, etc.) and the like.

The green sheet of such glass-ceramic substrate material is formed by a conventional method such as doctor blading, roll coating, calendering and the like. Typical methods are disclosed in U.S. Patent Nos. 4,301,324 and 4,234,367.

On the green sheet, the electrode pattern is formed by a conventional method such as screen printing and the like.

The green sheets having the electrode pattern are laminate stacked to obtain a laminate of the green sheets. The lamination conditions include a temperature of 50 to 150°C and pressure of 50 to 200 kg/cm$^2$. The laminate stacking method is disclosed in U.S. Patent No. 4,234,367.

Specific examples of the inorganic material which is not sintered at a sintering temperature of the green sheets of the low-temperature firing substrate material or lower are $Al_2O_3$, MgO, $ZrO_2$, $TiO_2$, BeC, BN and the like.

The green sheets of the inorganic material can be laminated on the both surfaces of the green sheet laminate of the low-temperature firing substrate material at a temperature of 50 to 150°C under pressure of 50 to 200 kg/cm$^2$. This step may be done in the lamination step of the low temperature sintered substrates.

The laminate sandwiched by the green sheets which comprises the inorganic material is wintered by first burning out the binder at a temperature of 400 to 750°C in an air for a suitable time, for example, one hour and then heating (sintering) the laminate at a temperature of 800 to 1000°C in the air for a suitable time, for example, one hour using a suitable furnace such as a belt furnace.

After sintering, the unsintered inorganic material layers are removed by a conventional method such as sand blast, ultrasonic cleaning, brushing, water-jetting and the like.

Alternatively, the inorganic material layers are impregnated with a resin and forming a top layer wiring pattern thereon.

Examples of the resin are epoxy resins, polyimide resins, silicone resins, acryl resins, phenolic resins, urethane resins and the like.

DESCRIPTION OF THE PREFERRED EMBODIMENTS

The method for producing the multilayered ceramic substrate which does not shrink in the plane direction according to the present invention will be explained by making reference to the accompanying drawings.

Example 1

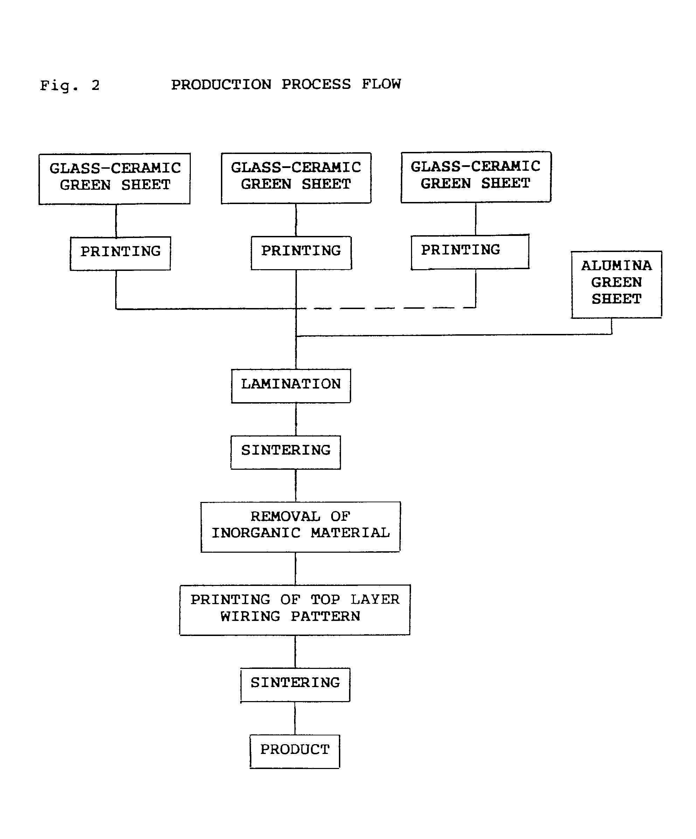

One embodiment of the method for producing the multilayered ceramic substrate is explained by making reference to Fig. 2.

As a glass-ceramic substrate material, a composition of lead borosilicate glass powder and alumina powder as a ceramic in a weight ratio of 50:50 (MLS-19 manufactured by Nippon Electric Glass Co., Ltd.) was used. This glass-ceramic powder, polyvinyl butyral as a binder, di-n-butyl phthalate as a plasticizer and a mixed solvent of toluene and isopropanol in a weight ratio of 30:70 were mixed to prepare a slurry.

The slurry was cast on an organic film (PET) with a doctor blade to form a sheet. In this step, a process for for continuously carrying out sheeting, drying, blanking and optionally via hole forming was employed. On the formed green sheet, a conductor pattern was formed with a silver paste and then via holes were filled both by screen printing. The silver paste was prepared by mixing silver powder having an average particle size of 1 $\mu$m, 5 % by weight of glass frits (GA-9 glass powder manufactured by Nippon Electric Glass Co., Ltd. having an average particle size of 2.5 $\mu$ m) which imparts adhesion strength and a vehicle comprising ethyl cellulose as an organic binder dissolved in $\alpha$-terpineol using three level rolls to a suitable viscosity. A silver paste for via filling further contained 15 % by weight of the above glass-ceramic powder.

The substrate green sheet had a thickness of about 200 $\mu$m.

A green sheet which is not sintered was prepared by the same method as above except that only alumina (AL-41 manufactured by Sumitomo Aluminum Co., Ltd.) was used as an inorganic component. This green sheet of the inorganic material had a thickness of about 300 $\mu$m.

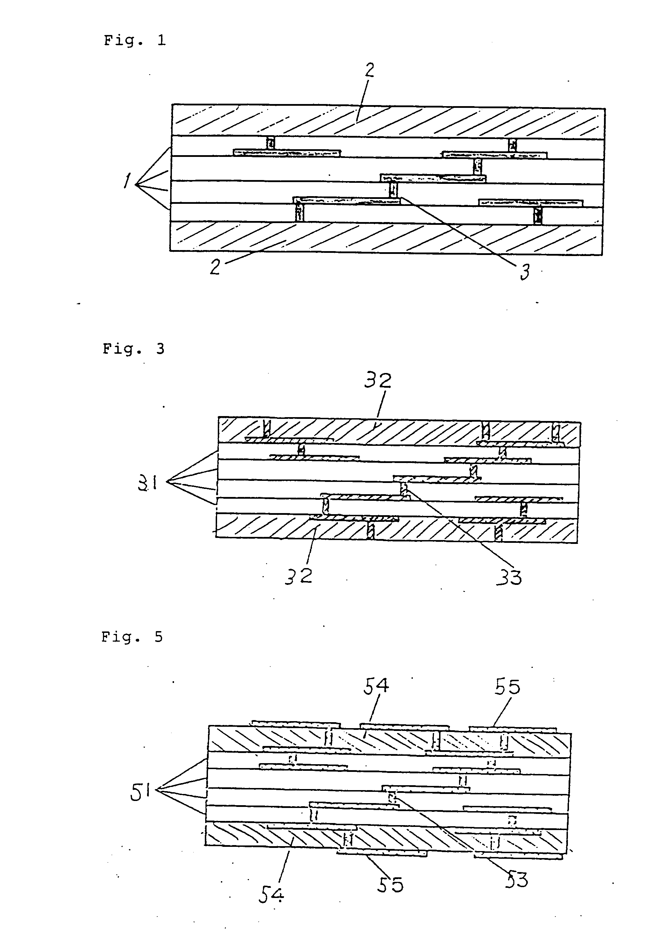

For the production of a substrate of Fig. 1, four substrate green sheets bearing the wiring patterns were laminated. On both surfaces of the laminate, the alumina green sheets were laminated. A composite of the green sheets was thermocompressed at 80°C under 200 kg/cm$^2$ to obtain an unsintered multilayered ceramic substrate having the structure of Fig. 1, which comprises the glass-ceramic green sheets 1, the alumina green sheets 2 and the internal electrodes 3.

Then, the compressed laminate was sintered on an 96 % alumina plate. The laminated was heated at a heating rate of 100°C/hr in an air up to 500°C to burn out the binder and then sintered in an electric belt furnace in the air at 900°C for one hour including a retention time of about 12 minutes at 900°C.

After sintering, the alumina layers were removed from the laminate by ultrasonic cleaning in butyl acetate. The alumina layers were completely removed.

A shrinkage factor of the substrate was less than 0.1 %. A shrinkage in the thickness direction was about 35 %. These results mean that the substrate does not shrink in the plane direction.

On the surface of the multilayered ceramic substrate, a top layer wiring pattern of a silver-palladium paste was screen printed and sintered under the same conditions as above. Since the shrinkage of the substrate was very small, there was no shear in printing of the top layer wiring pattern.

Comparative Example 1

A conventional multilayered ceramic substrate was produced by the same manner as above but using no alumina green sheets.

The properties of the multilayered ceramic substrates produced in Example 1 and Comparative Example 1 are shown in Table 1.

Table 1

| Property | Example 1 | Comp. Ex. 1 |
|---|---|---|
| Shrinkage (%) | | |
|     in plane direction | <0.1 | 13.5 |
|     in thickness direction | 36.3 | 18.3 |
| Density after sintering (g/cm$^3$) | 3.12 | 3.18 |
| Coefficient of thermal expansion (ppm/°C) | 6.12 | 6.01 |
| Flexural strength (kg/cm$^2$) | 2600 | 2680 |
| Surface roughness (±μm) | 1.8 | 1.4 |
| Dielectric constant | 7.7 | 7.9 |
| Insulation resistance (x $10^{13}$) | 4.6 | 9.0 |
| Adhesion strength of top layer electrode (kgf) | 2.80 | 2.27 |

As understood from the above results, the multilayered ceramic substrate of the present invention shrinks only in the thickness direction but hardly shrinks in the plane. In addition, the multilayered ceramic substrate produced by the method of the present invention has substantially the same properties as the ceramic substrate produced by the conventional method.

The surface roughness of the substrate of the present invention was larger than that of the conventional one. This may be because the alumina powder remained on the glass-ceramic layer. But, the above surface roughness is practically acceptable.

The multilayered ceramic substrate of the present invention has the larger adhesion strength of the top layer electrode than the conventional one. This may be due to the larger surface roughness of the substrate of the present invention.

This adhesion strength was measured soldering a lead wire having a diameter of 0.6 mm on a 2 mm square electrode pad in an L figure and pulling the lead wire in a direction perpendicular to the substrate. The strength at break was used as the adhesion strength of the top layer electrode.

Example 2

A glass-ceramic green sheet was prepared using the same composition as used in Example 1. On the green sheet, a conductor pattern was formed with a CuO paste and then via holes were filled both by screen printing. The CuO paste was prepared by mixing CuO powder having an average particle size of 3 μm, 3 % by weight of glass frits (LS-0803 glass powder manufactured by Nippon Electric Glass Co., Ltd. having an average particle size of 2.5 μm) which imparts adhesion strength and a vehicle comprising ethyl cellulose as an organic binder dissolved in α-terpineol using three level rolls to a suitable viscosity. A CuO paste for via filling further contained 15 % by weight of the above glass-ceramic powder.

The substrate green sheet had a thickness of about 200 μm.

A green sheet which is not sintered was prepared by the same method as above except that only beryllium oxide having an average particle size of 1 μm (manufactured Kanto Chemical Co., Ltd.) was used as an organic component. This green sheet of the inorganic material had a thickness of about 300 μm.

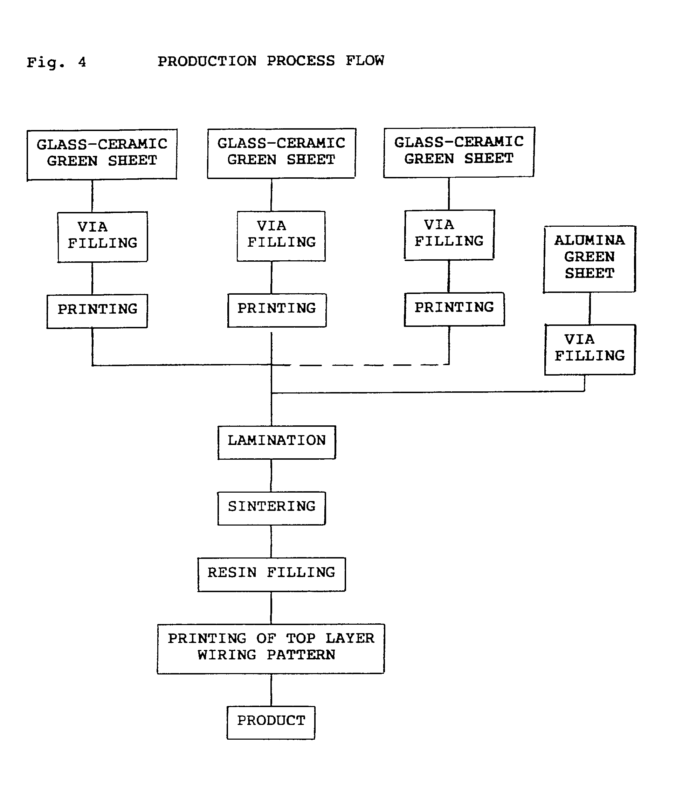

For the production of a substrate of Fig. 3, four substrate green sheets bearing the wiring patterns were laminated. On both surfaces of the laminate, the alumina green sheets were laminated. A composite of the green sheets was thermocompressed at 80°C under 200 kg/cm$^2$ to obtain an unsintered multilayered ceramic substrate having the structure of Fig. 1, which comprises the glass-ceramic green sheets 31, the alumina green sheets 32 and the internal electrodes 33.

Then, the compressed laminate was sintered as follows:

First, the binders were burnt out. Since the used binders were polyvinyl butyral for the green sheets and ethyl cellulose for the CuO paste, they can be decomposed at a temperature higher than 500°C in an air. Then, in this Example, the binders were burnt out at 600°C in the air. Thereafter, the laminate was reduced in a 100 % hydrogen atmosphere at 200°C for 5 hours. The Cu layer was analyzed by X-ray diffraction and the formation of 100 % Cu was confirmed. The laminate was then sintered in the electric mesh belt furnace at 900°C in a pure nitrogen atmosphere.

After sintering, the beryllium oxide layers were removed from the laminate by the same ultrasonic cleaning as in Example 1.

A shrinkage factor of the substrate was less than 0.05 %. Other properties were substantially the same as those in Example 1.

On the surface of the multilayered ceramic substrate, a top layer wiring pattern of a copper paste (#QP 153 manufactured by DuPont) was screen printed and sintered under the same conditions as above. The adhesion strength of the top layer electrode was 2.65 kgf.

When MgO, $ZrO_2$, $TiO_2$ or BN was used in place of alumina or beryllium oxide in Example 1 or 2, the same results were achieved.

In the above Examples, the top layer electrode was formed after the sintering of the substrate. But, the top layer electrode can be printed on the surface of the laminated green sheets and sintered.

Example 3

In this Example, a multilayered ceramic substrate was produced by the method illustrated in Fig. 4.

As a glass-ceramic substrate material, a composition of lead borosilicate glass powder and alumina powder as a ceramic in a weight ratio of 50:50 (MLS-19 manufactured by Nippon Electric Glass Co., Ltd.) was used. This glass-ceramic powder, polybutyl methacrylate as a binder, di-n-butyl phthalate as a plasticizer and methyl ethyl ketone as a solvent were mixed to prepare a slurry.

The slurry was coated on an organic film with a doctor blade to form a sheet. In this step, a process for continuously carrying out sheeting, drying, blanking and optionally via hole forming was employed. On the formed green sheet, a conductor pattern was formed with a silver paste and then via holes were filled both by screen printing. The silver paste was prepared by mixing silver powder having an average particle size of 1 μm, 5 % by weight of glass frits (GA-9 glass powder manufactured by Nippon Electric Glass Co., Ltd. having an average particle size of 2.5 μ m) which imparts adhesion strength and a vehicle comprising ethyl cellulose as an organic binder dissolved in α-terpineol using three level rolls to a suitable viscosity. A silver paste for via filling further contained 15 % by weight of the above glass-ceramic powder.

The substrate green sheet had a thickness of about 200 μm.

A green sheet which is not sintered was prepared by the same method as above except that only alumina (AL-41 manufactured Sumitomo Aluminum Co., Ltd.) was used as an inorganic component. This green sheet of alumina had a thickness of about 300 μm.

In the alumina green sheet, via holes each having a diameter of 0.15 mm were formed by punching.

For the production of a substrate of Fig. 3, four substrate green sheets bearing the wiring patterns were laminated. On both surfaces of the laminate, the alumina green sheets were laminated. A composite of the green sheets was thermocompressed at 80°C under 200 kg/cm² to obtain an unsintered multilayered ceramic substrate having the structure of Fig. 3, which comprises the glass-ceramic green sheets 31, the alumina green sheets 32 and the internal electrodes 33.

Then, the compressed laminate was sintered on an 96 % alumina plate. The laminated was heated in an air at 500°C to burn out the binder and then sintered in an electric belt furnace in the air at 900°C for one hour including a retention time of about 12 minutes at 900°C.

The substrate did not shrink in the plane direction.

Then, the sintered laminate was heated at 150°C in the air, and an epoxy resin was dropped on one surface of the laminate, impregnated in the unsintered alumina layer and cured. On the other surface of the laminate, the epoxy resin was impregnated in the same manner as above. Thereby, voids of the both unsintered alumina layers were filled with the epoxy resin.

The shrinkage factor of the substrate was less than 0.05 %.

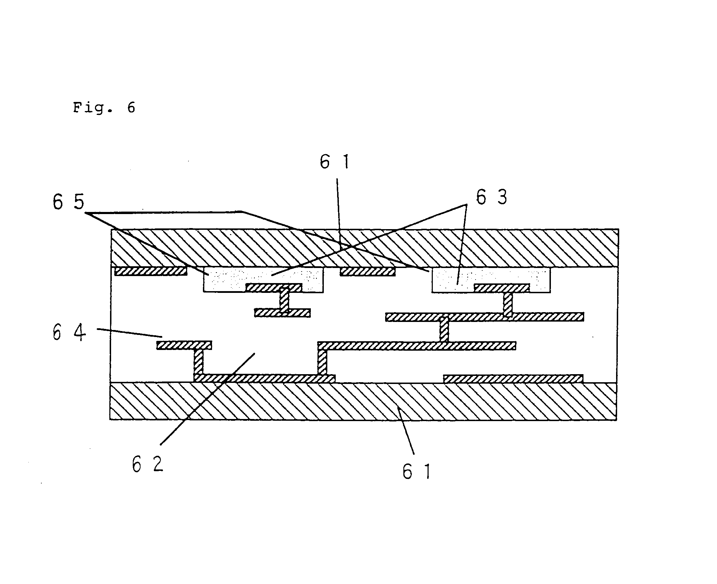

The entire surfaces of the substrate was abrased to expose the via wirings and plated with copper at a thickness of about 35 μm by the electroless copper plating or the electrolytic copper plating. Then, the plated copper layers were etched to form desired wiring patterns. A cross sectional view of the produced substrate is shown in Fig. 5. The substrate comprises the glass-ceramic substrate layers 51, the internal electrodes 53, the unsintered alumina layers 54 impregnated with the epoxy resin, and the top layer wiring patterns of copper 55.

The multilayered ceramic substrates produced in this Example did not shrink in the plane direction and had good mechanical strength and high accuracy. Since the wiring patters in the ceramic layers shrunk very slightly, there was no slippage of the top layer wiring patterns. Such substrate is suitable for the assembly of a multi-tip module which requires highly precise wirings.

Example 4

As the glass-ceramic green sheets, those having the same composition as that used in Example 3 were used. On each of the green sheets, a conductor pattern was formed with a CuO paste and then via holes were filled both by screen printing. The CuO paste was prepared by mixing CuO powder having an average particle size of 3 μm, 3 % by weight of glass frits (LS-0803 glass powder manufactured by Nippon Electric Glass Co., Ltd. having an average particle size of 2.5 μm) which imparts adhesion strength and a vehicle comprising polybutyl methacrylate as an organic binder dissolved in α-terpineol using three level rolls to a suitable viscosity. A CuO paste for via filling further contained 15 % by weight of the above glass-ceramic powder.

The substrate green sheet had a thickness of about 200 μm.

A green sheet which is not sintered was prepared by the same method as above except that only magnesium oxide (manufactured Kanto Chemical Co., Ltd.) was used as an inorganic component was used as the inorganic component. This green sheet of the inorganic material had a thickness of about 300 μm.

The predetermined number of substrate green sheets bearing the wiring patterns were laminated. On both surfaces of the laminate, the magnesium oxide green sheets were laminated. A composite of the green sheets was thermocompressed at 80°C under 200 kg/cm² to obtain an unsintered multilayered ceramic substrate.

Then, the compressed laminate was sintered as follows:

First, the binders were burnt out. Since the used binders were polybutyl methacrylate for the green sheets and the CuO paste, they can be decomposed at a temperature higher than 450°C in an air. Then, in this Example, the binders were burnt off at 500°C in the air. Thereafter, the laminate was reduced in a 100 % hydrogen atmosphere at 200°C for 5 hours. The Cu layer was analyzed by X-ray diffraction and the formation of 100 % Cu was confirmed. The laminate was then sintered in the electric mesh belt furnace at 900°C in a pure nitrogen atmosphere.

After sintering, the magnesium oxide layers were filled with the resin in the same manner as in Example 3. A solution of a monomer of polyimide dissolved in chloroform was dropped on one surface of the laminate and dried. Then, this surface of the substrate was abrased to expose the via wirings and laminated with a copper foil having a thickness of about 35 μm, followed by heat treating at 300°C, whereby the adhesion strength between the copper foil and the polyimide layer was improved. Then, the copper foil layer was etched to form a desired wiring pattern. The shrinkage factor of the produced substrate was less than 0.05 %.

When $ZrO_2$, $TiO_2$, BN or BeO was used in place of MgO, the same results as above were achieved.

When the unsintered green sheet layer is placed on one side of the laminated substrate green sheet, only the side having no unsintered green sheet is sintered so that the sintered substrate warps.

In this Example, as the filling resin, a silicone resin, an acryl resin, a phenol resin or a urethane resin can be used in place of the epoxy resin or the polyimide resin.

Since the produced substrate has good dimensional stability, it is possible to directly mount the semiconductors and the like on the substrate.

Example 5

This Example explains a method for producing a multilayered ceramic substrate having cavities on its surface.

The production steps are substantially the same as those of Fig. 2.

As a glass-ceramic substrate material, a composition of lead borosilicate glass powder and alumina powder as a ceramic in a weight ratio of 50:50 (MLS-21 manufactured by Nippon Electric Glass Co., Ltd.) was used. This glass-ceramic powder, polyvinyl butyral as a binder, di-n-butyl phthalate as a plasticizer and methyl ethyl ketone were mixed to prepare a slurry.

The slurry was coated on an organic film with a doctor blade to form a sheet. In this step, a process for for continuously carrying out sheeting, drying, blanking and optionally via hole forming was employed. On the formed green sheet, a conductor pattern was formed with a silver paste and then via holes were filled both by screen printing. The silver paste was prepared by mixing silver powder having an average particle size of 1 μm, 5 % by weight of glass frits (GA-9 glass powder manufactured by Nippon Electric Glass Co., Ltd. having an average particle size of 2.5 μ m) which imparts adhesion strength and a vehicle comprising ethyl cellulose as an organic binder dissolved in α-terpineol using three level rolls to a suitable viscosity. A silver paste for via filling further contained 15 % by weight of the above glass-ceramic powder.

The substrate green sheet had a thickness of about 300 μm.

The predetermined number of the green sheets were laminated and heat pressed at 80°C under 100 kg/cm² to form a laminate. Cavities present on the surface were filled with an inorganic powder which is not sintered at the sintering temperature. As the inorganic powder composition, alumina having an average particle size

of 1.9 μm (AL-41 manufactured by Sumitomo Aluminum Co., Ltd.) was used. Fig. 6 shows a cross sectional view of a substrate having the cavities 65 on the laminate 62. The cavities were filled by the alumina powder 63. The numeral 64 represents the internal electrodes. The laminate was then molded under 200 kg/cm².

Thereafter, a pair of alumina green sheets 61 each having a thickness of about 300 μm were placed on the both side of the laminate and heat thermocompressed.

Then, the compressed laminate was sintered on an 96 % alumina plate. The laminated was heated in the air at 500°C to burn out the binder and then sintered in an electric belt furnace in the air at 900°C for one hour including a retention time of about 12 minutes.

After sintering, the alumina layers were removed from the laminate by ultrasonic cleaning in butyl acetate. The unsintered alumina layers and the alumina powder in the cavities were completely removed.

A shrinkage factor of the substrate was less than 0.1 %. This result means that the substrate dis not shrink in the plane direction.

On the surface of the multilayered ceramic substrate, a top layer wiring pattern of a silver-palladium paste was screen printed and sintered under the same conditions as above. Since the shrinkage of the substrate was very small, there was no shear in printing of the top layer wiring pattern.

Since the substrate does not shrink in the method of the present invention, it is possible to produce the multilayered ceramic substrate having high accuracy even when the substrate surface has the cavities. This is favorable for the production of a ceramic package which is used as a semiconductor package and the like.

According to the present invention, it is possible to produce a multilayered ceramic substrate which shrinks only in the thickness direction and does not shrink in the plane direction without using special materials or complicated processes. Thereby, the multilayered ceramic substrate having the same size can be always produced without depending on the substrate material, the green sheet composition or the powder lot.

When the top layer wiring pattern is formed after the sintering of the internal wiring patterns in the production of the multilayered ceramic substrate, the complete connection is formed between the internal wiring patterns and the top layer wiring pattern. As the result, the land area for connection can be decreased and therefore the high density multilayered wiring substrate can be produced. Further, the number of screens is decreased, and it is not necessary to enlarge the internal wiring pattern depending on the shrinkage factor.

## Claims

1. A method for producing a multilayered ceramic substrate comprising steps of:
   forming at least two green sheets each of which comprises a glass-ceramic low-temperature firing substrate material, an organic binder and a plasticizer,
   forming an electrode pattern with a conductor paste composition on each of said green sheets
   laminating said green sheets having the electrode pattern to obtain a laminate,
   laminating a pair of green sheets each comprising an inorganic material which is not sintered at a sintering temperature of the green sheets of the low-temperature firing substrate material or lower on both surfaces of said laminate,
   sintering said laminate sandwiched by the green sheets comprising the inorganic material, and removing the unsintered inorganic material.

2. The method according to claim 1, wherein said laminated is sintered at a temperature of 800 to 1000°C.

3. The method according to claim 1, wherein said inorganic material is at least one compound selected from the group consisting of $Al_2O_3$, MgO, $ZrO_2$, $TiO_2$, BeO and BN.

4. The method according to claim 1, wherein said unsintered inorganic material is removed by ultrasonic cleaning.

5. The method according to claim 1, wherein said conductor paste comprises a component selected from the group consisting of silver, silver-palladium, silver-platinum and copper.

6. A method for producing a multilayered ceramic substrate comprising steps of:
   forming at least two green sheets each of which comprises a glass-ceramic low-temperature firing substrate material, an organic binder and a plasticizer,
   forming an electrode pattern with a conductor paste composition comprising cupric oxide on each of said green sheets,

laminating said green sheets having the electrode pattern to obtain a laminate,

laminating a pair of green sheets each comprising an inorganic material which is not sintered at a sintering temperature of the green sheets of the low-temperature firing substrate material or lower on both surfaces of said laminate,

heating said laminate at a temperature at which said organic binder is decomposed and removed, reducing cupric oxide in an atmosphere of hydrogen or a mixture of hydrogen and nitrogen, sintering said reduced laminate in a nitrogen atmosphere, and

removing the unsintered inorganic material.

7. The method according to claim 6, which further comprises, after the removal of said unsintered inorganic material, forming a top layer wiring pattern with a copper paste and sintering the laminate in a nitrogen atmosphere.

8. The method according to claim 6, wherein said laminated is sintered at a temperature of 800 to 1000°C.

9. The method according to claim 6, wherein said inorganic material is at least one compound selected from the group consisting of $Al_2O_3$, $MgO$, $ZrO_2$, $TiO_2$, $BeO$ and $BN$.

10. The method according to claim 6, wherein said unsintered inorganic material is removed by ultrasonic cleaning.

11. A method for producing a multilayered ceramic substrate comprising steps of:

forming at least two green sheets each of which comprises a glass-ceramic low-temperature firing substrate material, an organic binder and a plasticizer,

forming an electrode pattern with a conductor paste composition on each of said green sheets

laminating said green sheets having the electrode pattern to obtain a laminate,

filling via holes with a conductor paste composition,

laminating a pair of green sheets each comprising an inorganic material which is not sintered at a sintering temperature of the green sheets of the low-temperature firing substrate material or lower on both surfaces of said laminate,

sintering said laminate sandwiched by the green sheets comprising the inorganic material,

impregnating the inorganic material layers with a resin and forming a top layer wiring pattern on at least one surface of the laminate.

12. The method according to claim 11, wherein said laminated is sintered at a temperature of 800 to 1000°C.

13. The method according to claim 11, wherein said inorganic material is at least one compound selected from the group consisting of $Al_2O_3$, $MgO$, $ZrO_2$, $TiO_2$, $BeO$ and $BN$.

14. The method according to claim 11, wherein said resin for impregnating the inorganic material layers is at least one resin selected from the group consisting of an epoxy resin, a polyimide resin, a silicone resin, an acryl resin, a phenolic resin and a urethane resin.

15. The method according to claim 11, wherein said conductor paste comprises a component selected from the group consisting of silver, silver-palladium, silver-platinum and copper.

16. The method according to claim 11, wherein said top layer wiring pattern is formed by laminating a copper foil on the resin-impregnated layer and etching the copper foil.

17. The method according to claim 11, wherein said top layer wiring pattern is formed by plating the resin impregnated surface with copper and etching the plated copper layer.

18. A method for producing a multilayered ceramic substrate comprising steps of:

forming at least two green sheets each of which comprises a glass-ceramic low-temperature firing substrate material, an organic binder and a plasticizer,

forming an electrode pattern with a conductor paste composition on each of said green sheets

laminating said green sheets having the electrode pattern to obtain a laminate,

filling cavities present on at least one surface of said laminate with an inorganic material powder which is not sintered at a sintering temperature of the green sheets of the low-temperature firing substrate material or lower under pressure,

laminating a pair of green sheets each comprising an inorganic material which is not sintered at a sintering temperature of the green sheets of the low-temperature firing substrate material or lower on both surfaces of said laminate,

sintering said laminate sandwiched by the green sheets comprising the inorganic material, and

removing the unsintered inorganic material.

19. The method according to claim 18, wherein said laminated is sintered at a temperature of 800 to 1000°C.

20. The method according to claim 18, wherein said inorganic material is at least one compound selected from the group consisting of $Al_2O_3$, MgO, $ZrO_2$, $TiO_2$, BeO and BN.

21. The method according to claim 18, wherein said unsintered inorganic material is removed by ultrasonic cleaning.

22. The method according to claim 18, wherein said conductor paste comprises a component selected from the group consisting of silver, silver-palladium, silver-platinum and copper.

23. The method according to claim 18, wherein said cavities are filled with said inorganic material powder under pressure of 50 to 500 kg/cm$^2$.

24. A method for producing a multilayered ceramic substrate comprising steps of:

forming layers of an inorganic material powder which is not sintered at a sintering temperature on both surfaces of a glass-ceramic laminate having cavities on its surfaces under pressure,

sintering said laminate, and

removing the unsintered inorganic material.

25. The method according to claim 24, wherein said laminated is sintered at a temperature of 800 to 1000°C.

26. The method according to claim 24, wherein said inorganic material is at least one compound selected from the group consisting of $Al_2O_3$, MgO, $ZrO_2$, $TiO_2$, BeO and BN.

27. The method according to claim 24, wherein said unsintered inorganic material is removed by ultrasonic cleaning.

28. The method according to claim 24, wherein said conductor paste comprises a component selected from the group consisting of silver, silver-palladium, silver-platinum and copper.

29. The method according to claim 24, wherein said cavities are filled with said inorganic material powder under pressure of 50 to 500 kg/cm$^2$.

Fig. 1

Fig. 3

Fig. 5

Fig. 2          PRODUCTION PROCESS FLOW

```
┌──────────────┐  ┌──────────────┐  ┌──────────────┐
│ GLASS-CERAMIC│  │ GLASS-CERAMIC│  │ GLASS-CERAMIC│
│ GREEN SHEET  │  │ GREEN SHEET  │  │ GREEN SHEET  │
└──────────────┘  └──────────────┘  └──────────────┘
        │                 │                 │
   ┌─────────┐       ┌─────────┐       ┌─────────┐           ┌──────────┐
   │PRINTING │       │PRINTING │       │PRINTING │           │ ALUMINA  │
   └─────────┘       └─────────┘       └─────────┘           │  GREEN   │
        │                 │                 │                │  SHEET   │
        └─────────────────┼─ ─ ─ ─ ─ ─ ─ ─ ─┘                └──────────┘
                          │                                        │
                          └────────────────────────────────────────┘
                          │
                  ┌───────────────┐
                  │  LAMINATION   │
                  └───────────────┘
                          │
                  ┌───────────────┐
                  │  SINTERING    │
                  └───────────────┘
                          │
            ┌──────────────────────────┐
            │      REMOVAL OF          │
            │  INORGANIC MATERIAL      │
            └──────────────────────────┘
                          │
          ┌──────────────────────────────┐
          │   PRINTING OF TOP LAYER      │
          │      WIRING PATTERN          │
          └──────────────────────────────┘
                          │
                  ┌───────────────┐
                  │  SINTERING    │
                  └───────────────┘
                          │
                   ┌─────────────┐
                   │  PRODUCT    │
                   └─────────────┘
```

Fig. 4      PRODUCTION PROCESS FLOW

EP 0 535 711 A2

Fig. 6